# EUROPEAN PATENT SPECIFICATION

(11) **EP 2 690 923 B1**
(45) Date of publication and mention of the grant of the patent: **25.03.2020**
(21) Application number: 12177478.0
(22) Date of filing: 23.07.2012
(51) Int. Cl.: H03K 17/082, H05B 6/06

(54) **A power supply device for a household appliance and an operating method thereof**
Energieversorgungsvorrichtung für ein Haushaltsgerät und Steuerungsverfahren dafür
Dispositif d'alimentation électrique pour appareil électroménager et son procédé d'utilisation

(43) Date of publication of application: 29.01.2014
(73) Proprietor: Whirlpool Corporation, Benton Harbor, MI 49022 (US)
(72) Inventor: Pastore, Cristiano, 21025 Comerio (IT); Gutierrez, Diego N., 21025 Comerio (IT); Maranzana, Alberto, 21025 Comerio (IT); Frasca, Michele, 21025 Comerio (IT); Sfriso, Fabio, 21025 Comerio (IT)
(74) Representative: Spina, Alessandro

(56) References cited:
- WO-A2-2004/068904
- JP-A- 11 111 441

## Description

The present invention relates to a power supply device for supplying electric power to a household appliance.

In a further aspect, the present invention relates to a method for operating a power supply device for a household appliance.

A power supply device for a household appliance, such as a cook-top or a microwave oven, generally comprises an AC-AC switching converter, which is electrically connected with the mains and provides a driving current having adjustable frequency and amplitude to feed a load, such as the induction coil of a cook-top or the primary winding of a step up transformer feeding a magnetron device.

In a power supply device for a household appliance, a controller is typically adopted for controlling the operation of the converter.

Such a controller operates the switching device of the converter in a continuous regime and performs a cycle-by-cycle regulation of the input current (or power) adsorbed by the power supply device.

Often, PWM modulation techniques are adopted to adjust a control quantity used for controlling said switching device (e.g. the switching frequency or duty cycle), so that the input current follows a reference value (set-point).

As is known, the switching device of the converter may be subject to sudden over-voltage phenomena, during its operating life.

Over-voltages may be due to different reasons, such as the occurrence of a surge event in the mains or changes of the mains voltage, and may seriously damage the switching device.

For this reason, traditional power supply devices generally incorporate protection circuits that are operatively associated with the switching device to limit the voltage applied at the terminals of this latter.

Exemplary protection circuits of this kind are disclosed in published US patent applications US 2004/0169975 and US 2008/0084642.

WO 2004/068904 A2 discloses a power supply device according to the preamble of claim 1 in which switch operations are immediately stopped in case an excessive over-voltage event occurs.

These known solutions do not often provide satisfactory performances in terms of over-voltage protection.

Further, the presence of the detected protection circuits entails an increase of the complexity of the circuit structure of the power supply device, with consequent higher industrial costs.

Therefore, the main aim of the present invention is to provide a power supply device for a household appliance, and an operating method thereof, which allows the overcoming of the drawbacks mentioned above.

Within this aim, it is an object of the present invention to provide a power supply device, and an operating method thereof, which ensures an effective protection against possible over-voltage phenomena at the terminals of the switching device of the AC-AC converter.

A further object of the present invention is to provide a power supply device, and an operating method thereof, which can be easily implemented using relatively simple, cheap circuitries and control techniques.

A further object of the present invention is to provide a power supply device, which is easy to manufacture at industrial level, at competitive costs.

Thus, the present invention provides a power supply device for a household appliance, according to claim 1.

In a further aspect, the present invention relates to a method for operating a power supply device for a household appliance, according to claim 7.

The scope of the invention is defined in the appended claims. Any reference to "embodiment(s)", "example(s)" or "aspect(s) of the invention" in this description not falling under the scope of the claims should be interpreted as illustrative example(s) for understanding the invention.

Further features and advantages of the present invention will become apparent from the following description of preferred embodiments, taken in conjunction with the drawings, in which:
- Fig. 1 shows a schematic diagram of an embodiment of the power supply device, according to the invention;
- Fig. 2-3 show the power supply device of Fig.1 in different operative conditions;
- Fig. 4-5 show graphs illustrating the operations of the power supply device of Fig. 1, in normal operating conditions;
- Fig. 6 shows some graphs illustrating one possible reaction of the power supply device of Fig. 1 according to the invention, when an over-voltage event occurring in a first part of T_{ON}, is detected.
- Fig. 7 shows some graphs illustrating one possible reaction of the power supply device of Fig. 1 according to the invention, when an over-voltage event occurring in a the second half of TON, is detected.

Referring now to the cited figures, the present invention relates to a power supply device 100 for a household appliance, in this case an induction hob.

The power supply device 100 is electrically connectable with the mains 10, from which it receives an input voltage V_{IN} and an input current I_{IN}, which are periodic electric quantities having mains semi-cycles of predefined duration. As an example, the duration of the mains semi-cycle is fixed at 10ms in 50Hz electric power distribution networks.

The power supply device 100 comprises a switching converter 110 that is electrically connected in parallel with the mains 10.

Preferably, the switching converter 110 is a Quasi-Resonant (Q-R) switching converter.

This choice allows to simplify the circuit structure of the power supply device 100 and it provides relevant advantages, since Q-R converters can be easily operated to constantly switch in zero voltage/current conditions ("soft switching" operation).

The switching converter 110 comprises a rectifying stage 12, for example a diode bridge, which is electrically connected with the mains to receive the input voltage V_{IN} and to output a rectified voltage.

The switching converter 110 comprises also an input filtering arrangement that comprises a filtering inductor L_{D}, which is electrically connected in series with one of the mains terminals. A bus capacitor 13, which is electrically connected in parallel with the output terminals of the rectifying stage 12, is part of said filtering arrangement.

Preferably, said filtering arrangement comprises also a further filtering capacitor C_{D}, electrically connected in parallel with the mains terminals.

The bus capacitor 13 is of a "non-smoothing" type, i.e. it has a relatively small capacitance value, so that the cut-off frequency of the filtering arrangement formed by the inductor L_{D} and the capacitor 13 is quite higher than the mains frequency.

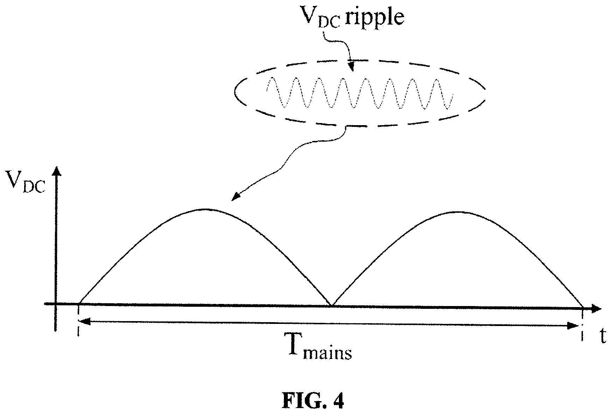

The bus voltage V_{DC} across the terminals A, B of the bus capacitor 13 substantially follows the behaviour of the rectified voltage provided by the rectifying stage 12, with fluctuations having a period equal to the half of a mains cycle Tₘₐᵢₙₛ (figure 4).

At least one of the terminals A, B of the bus capacitor 13 is electrically connected with a resonant tank 200, which comprises an inductive-resistive load, schematically represented by a load inductance L_{LOAD} and a load resistance R_{LOAD}.

Such an inductive-resistive load may be, for example, a pancake coil of an induction cook-top. The resonant tank 200 further comprises a resonant capacitor C_{RES} that is generally electrically connected in parallel with the inductive-resistive load L_{LOAD}, R_{LOAD}.

The switching converter 110 comprises a switching device 130, for example an IGBT switch, which is advantageously connected with the resonant tank 200.

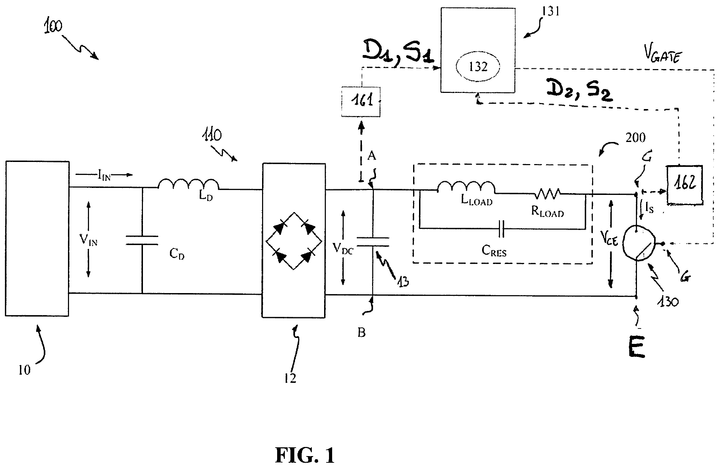

In the embodiment shown in figure 1, the switching device 130 is electrically connected in series with the whole resonant tank 200.

In other embodiments of the present invention, the switching device 130 may be differently connected with the components of the resonant tank 200.

For example, it may be electrically connected in series with the inductive-resistive load L_{LOAD}, R_{LOAD} and in parallel with the resonant capacitor C_{RES}.

The switching device 130 comprises an input terminals G, at which the switching device 130 receives control signals V_{GATE} capable of controlling its commutation state, and output terminals C, E, at which the switching device is electrically connected with the resonant tank 200 and the bus capacitor 13.

If the switch device 100 is an IGBT switch, or a similar switch, the terminal G is the gate terminal of the switching device 100 while the terminals C, E are respectively the collector and emitter terminals.

The power supply device 100 comprises a control loop for controlling the operation of the switching device 130.

Such a control loop preferably comprises control means 131 (e.g. a controller of digital or analogue type) that generates the control signals V_{GATE} for controlling the operation of the switching device 130.

If the switch device 100 is an IGBT switch, or a similar switch, the control signals V_{GATE} are voltage signals provided to the gate terminal G of the switching device 100.

Preferably, the control means 131 comprises a microprocessor or another digital processing device (figure 1).

In this case, the control means 131 preferably comprises computerised means 132, e.g. one or more sets of software instructions that can be stored or executed by said microprocessor or digital processing device.

In normal operating conditions (i.e. when no over-voltage events are determined to occur) the control means 131 operate the switching device 130 with a switching cycle T that is quite shorter than the mains cycle Tₘₐᵢₙₛ.

As an example, the duration of the switching cycle T may be of 40 µs while the duration of the mains cycle Tₘₐᵢₙₛ is typically 20 ms.

Basically, the switching cycle T is divided in two switching periods, each corresponding to a commutation state of the switching device 130 (figures, 2, 3 5).

During these switching periods the bus capacitor 13 is charged by the input current I_{IN} provided by the mains.

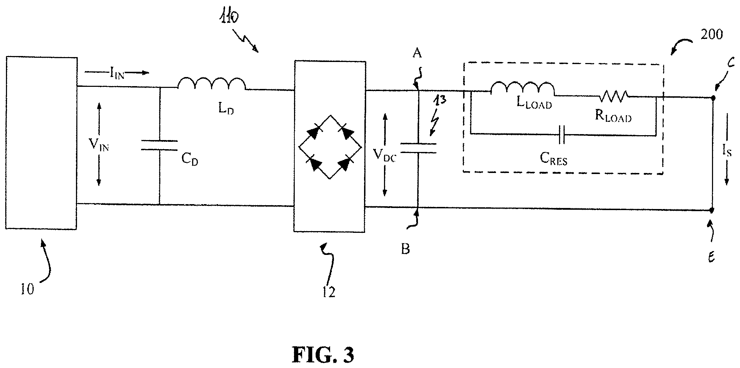

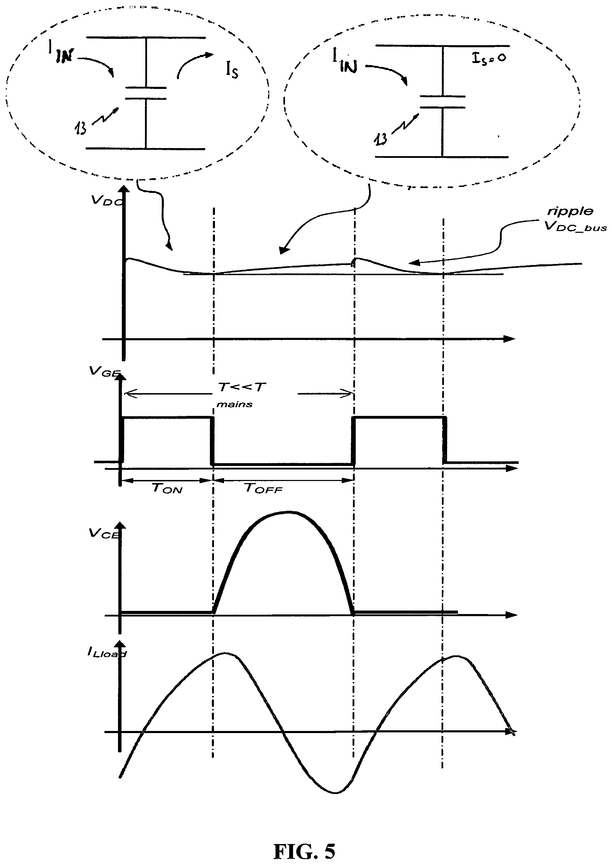

In a first switching period T_{ON}, the switching device 130 is in a conduction state and it allows the flow of a first current I_{S} between the bus capacitor 13 and the resonant tank 200 (figures 3, 5 - non resonating phase).

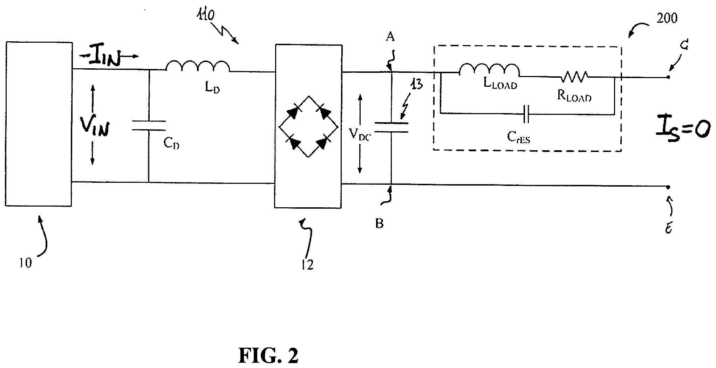

In a second switching period T_{OFF}, the switching device 130 is in an interdiction state and it blocks the flow of the current I_{S} between the bus capacitor 13 and the resonant tank 200 (figure 2). In this case, electric energy is exchanged only at local level, basically among the resonant capacitor C_{RES} and the load inductance L_{LOAD} (figures 2, 5 - resonating phase). Because of the relatively small capacitance value of the capacitor 13, the bus voltage V_{DC} shows a ripple (V_{DC} ripple) that has a frequency (calculated as 1/T) equal to the switching frequency of the switching device 130 (figures 4-5).

Preferably, the power supply device 100 comprises first detecting means 161, configured to provide the control means 131 with first detection data or signals D₁, S₁, indicative of the behaviour of the bus voltage V_{DC}.

Preferably, the detecting means 161 comprise a first voltage sensor (e.g. a resistive divider) that is arranged to advantageously output a first measuring signal S₁ indicative of the bus voltage V_{DC}.

If the mentioned control loop is analogically implemented, such a measuring signal S₁ may be directly sent to the control means 131.

If the mentioned control loop is digitally implemented, such a first voltage sensor is operatively associated with first sampling means that receive the measuring signal S₁ and provides the control means 131 with digital samples D₁ of the bus voltage V_{DC}.

According to alternative embodiments of the present invention, the detecting means 161 may comprise a voltage sensor for measuring a voltage at points of the switching converter 110 that are different from the terminals A, B of the capacitor 13, for example at the terminals of the filtering capacitor C_{D}.

In this case, the first measuring signal S₁ may be easily obtained from the measuring signal provided by said voltage sensor.

Other obvious solutions to obtain the measuring signal S₁ are within the capabilities of the skilled person.

Preferably, the power supply device 100 comprises second detecting means 162, configured to provide the control means 131 with second detection data or signals D₂, S₂, indicative of the behaviour of a switch voltage V_{CE}, at the output terminals C, E of the switch device 100.

If the switching device 100 is an IGBT switch or a similar switch, the switch voltage V_{CE} checked by the detecting means 162 is advantageously the collector-emitter voltage. Preferably, the detecting means 162 comprise a second voltage sensor (e.g. a resistive divider) that is arranged to output a second measuring signal S₂ indicative of the switch voltage V_{CE}. Also in this case, other obvious solutions to obtain the measuring signal S₂ are within the capabilities of the skilled person.

If the mentioned control loop is analogically implemented, such a measuring signal S₂ may be directly sent to the control means 131.

If the mentioned control loop is digitally implemented, such a second voltage sensor is operatively associated with second sampling means that receive the measuring signal S₂ and provides the control means 131 with digital samples D₂ of the switch voltage V_{CE}.

According to the invention, the control means 131 are configured to determine the occurrence of an over-voltage event, on the base of the first detection data or signals D₁, S₁ indicative the behaviour of the bus voltage V_{DC}, across the terminals A, B of the bus capacitor 13.

Within the framework of the present invention, the term "over-voltage event" identifies an anomalous rising of the voltage provided by the mains. Such an anomalous rising may be due, for example, to a surge event in the mains, a change in the mains voltage or another anomalous phenomenon.

Preferably, the control means 131 determine the occurrence of an over-voltage event on the base of a rate of change (first derivative over time) of the bus voltage V_{DC}.

To this aim, the control means may calculate the rate of change of the bus voltage V_{DC} using values of the bus voltage V_{DC} taken at different sampling instants t₁, t₂ and compare the rate of change so calculated with a predefined or variable first reference value (not shown).

As an alternative, the control means 131 may determine the occurrence of an over-voltage event by simply comparing the bus voltage V_{DC} with a first threshold value V_{TH}, which may be predefined or variable depending on the needs.

Both these solutions may be easily implemented in an analogue or, preferably, digital manner. In the first case, the control means 131 may comprise a determining circuit (not shown) configured to receive the measuring signals S₁ and determine the occurrence of an over-voltage event.

In the second case, the control means 131 may comprise computerised determining means (not shown), i.e. one or more sets of software instructions configured to process the sample data D₁ and determine the occurrence of an over-voltage event.

According to the invention, when an over-voltage event is determined, the control means 131 operate the switching device 130, so as to bring or maintain the switch voltage V_{CE}, across the output terminals C, E of this latter, within predefined safety limits. This safety limit is sufficiently lower than the device breakdown limit V_{CE_break}, which represents the rating of the used component. Preferably, this limit is a voltage value comprised between 70% and 98% of said device breakdown limit V_{CE_break} More preferably, this limit is between 85% and 95% of said device breakdown limit V_{CE}__{break},. Advantageously this limit is around 90% of the device breakdown limit V_{CE}__{break}.

In the power supply 100, the protection of the switching device 130 from over-voltages is not ensured by properly arranged protection circuits, operatively associated with the switching device itself, as in traditional solutions.

According to the invention, the incoming of an over-voltage event is advantageously checked by monitoring the behaviour of the bus voltage V_{DC}.

When a possible over-voltage event is signalled, the control means 131 intervene on the commutation state of the switching device 130 and modify such a commutation state so as to avoid or reduce the arising of over-voltages at the terminals C, E of the switching device 100. According to an embodiment fo the present invention, if an over-voltage event is determined to occur during a first portion of the switching period T_{ON} of a switching cycle T (i.e. while the switching device 130 is in a conduction state) the control means 131 operate the switching device 130, so that this latter commutates into an interdiction state.

The first portion of the switching period T_{ON} may be for example the first half (0-50%) of the switching period T_{ON}. Of course, the first portion of the switching period T_{ON} may last differently, according to the needs.

Thanks to the described solution, the inductive-resistive load L_{LOAD} is prevented from storing an excessive amount of electric energy. The arising of over-voltages at the output terminals C, E of the switching device 130 is thus a priori avoided or limited.

Preferably, after it has been commutated, the switching device 130 is maintained in the interdiction state by the control means 131, until the bus voltage V_{DC} is below a first safety value V_{S1}.

Once the over-voltage event is overcome (the bus voltage V_{DC} is below the safety level V_{S1}), the switching device 130 may return to normally operate without risks of failure.

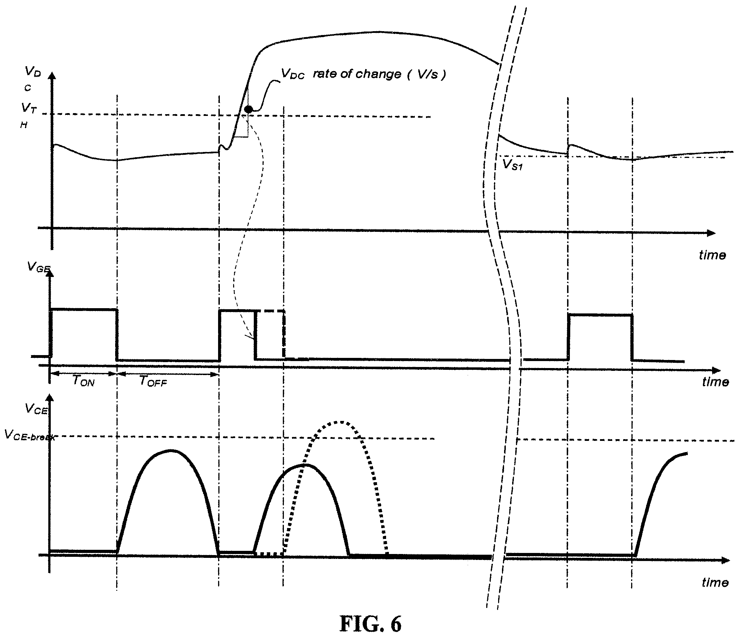

The behaviour of the power supply device 100, just described above, is illustrated by the graphs of figure 6.

As is shown, the occurrence of an over-voltage event is determined during the first half of the switching period T_{ON}.

The control means 131 generate a command signal V_{GATE} to commutate the switching device 130 into an interdiction state.

The switching device 130 is maintained in the interdiction state, so achieved, until the rate of change of the bus voltage V_{DC} or the bus voltage V_{DC} returns below the first safety value V_{S1}.

If an over-voltage event is determined to occur on a second portion (e.g. the second half or 50-100%) of the switching period T_{ON} or during the second switching period T_{OFF} of a switching cycle T (i.e. while the resonant capacitor C_{RES} is mostly charged or the switching device 130 is in an interdiction state), the previously described protection strategy would be ineffective. In fact, in this situation, the peak of the switch voltage V_{CE} is substantially equal to the sum of the normal peak value that would be experienced without an over-voltage event and the over-voltage caused by the over-voltage event on the capacitor 13.

To handle this situation, the control means 131 operate the switching device 130, so that this latter is subject to one or more sequences BURST of state commutations.

Preferably, each sequence BURST of state commutations comprises a predefined number (8 or 10) of state commutations.

The state commutations of each sequence BURST have duration T_{BURST} that is quite shorter that the switching cycle T.

As an example, the duration of the commutation cycle T_{BURST} may be of 1 µs with a duty cycle of 10% (i.e the duration of the switch activation may be of 100ns).

Preferably, the state commutations of each sequence BURST are not executed with a constant period.

Each state commutation is preferably separated from the following one by a time interval that increases during the execution of the sequence itself. In other words, the density of the state commutations decreases during the execution of each sequence BURST, i.e. it is higher at the beginning of each sequence BURST and lower at the end of each sequence BURST.

This solution is quite advantageous since the increase of the density of the state commutations at the beginning of each sequence BURST provides a quick stop of the increase of the V_{CE} voltage. On the other hand, the decrease of the density of the state commutations at the end of each sequence BURST avoids or limits a new arising of the V_{CE} voltage when the sequence BURST is completed.

However, alternative embodiments of the present invention may foresee that the time intervals between subsequent state commutations are substantially constant during the execution of the BURST sequences.

Preferably, also the duration D_{BURST} of each sequence BURST of state commutations is shorter than the switching cycle T of the switching device 130 (e.g. 10 µs).

Preferably, the switching device 130 is operated so as to be subject to one or more sequences BURST of state commutations, until the switch voltage V_{CE} is below a second safety value V_{S2}.

Preferably, at the end of the one or more sequences BURST of state commutations, the control means 131 operate the switching device 130, so that this latter commutates into an interdiction state.

Preferably, the switching device 130 is maintained in the interdiction state by the control means 131, until the rate of change of the bus voltage V_{DC} or the bus voltage V_{DC} gets below a third safety value V_{S3}.

Once the over-voltage event is overcome (i.e. the bus voltage V_{DC} gets below the safety level V_{S3}), the switching device 130 may in principle return to operate normally.

However the sequence of state commutations BURST generally causes a significant overheating of the switching device 130. Therefore, it is advantageous that the control means 131 inhibits the switching process for an idle time, comprised between 100ms and 10s, sufficient to cool down the junction below a safe level.

Thanks to the described operating mode imposed by the control means 131, the switching device 130 is capable of dissipating the electric energy stored by the resonant capacitor C_{RES}, without incurring in failures, once it returns to normal operation.

If the switching device 130 was simply maintained in an interdiction state, at the occurrence of an over-voltage event, the resonant voltage across the switching device 130 would likely exceed its maximum (the device breakdown voltage V_{CE_break}), resulting in an instantaneous and permanent damage of the switching device itself.

The same problem would arise if the switching device 130 is simply commutated in a conduction state, once the occurrence of an over-voltage event is determined.

Instead, since the working device 130 is subject to one or more sequences of fast state commutations, the electric energy stored by the resonant capacitor C_{RES} is gradually decreased.

Once the capacitors C_{BUS} and C_{RES} are substantially discharged (the switch voltage V_{CE} is below the safety level V_{S2}), the switching device 130 is maintained in an interdiction state for a while (until the rate of change of the bus voltage V_{DC} or the bus voltage V_{DC} is below the safety level V_{S3}).

In this way, the switching device 130 may return to its normal operative temperature after the multiple state commutations, to which it has been subject.

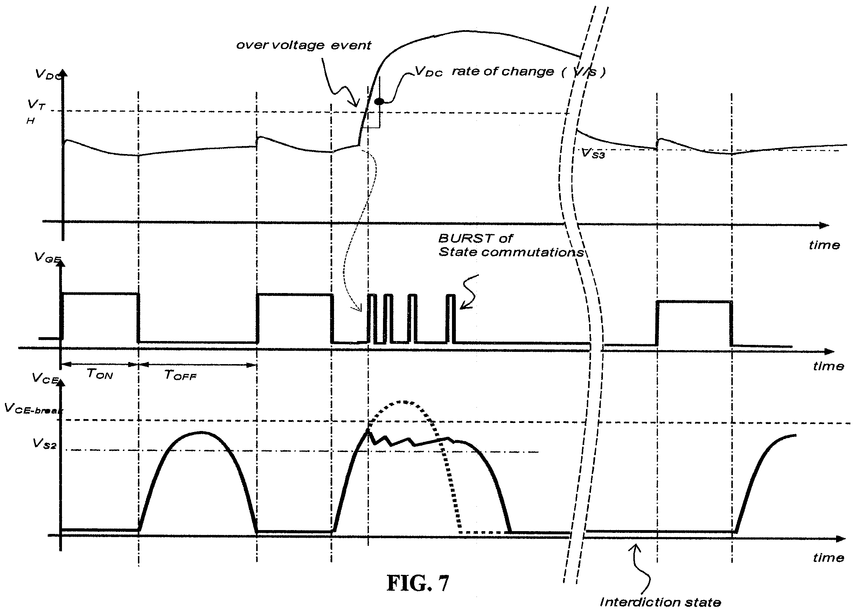

The operative behaviour of the power supply device 100, just described above, is shown by the graphs of figure 7.

As shown, the occurrence of an over-voltage event is determined during the switching period T_{OFF}, when the bus voltage V_{DC} or its first derivative, overcomes the first threshold value V_{TH} in such a switching period.

The control means 131 generate a pulsed command signal V_{GATE}, so as to submit the switching device 130 to a sequence BURST of state commutations.

In this case, the switching device 130 is subject to only one sequence BURST of state commutations, since after said sequence the switch voltage V_{CE} falls below the second safety value V_{S2}.

At the end of the sequence BURST of state commutations, the switching device 130 is commutated by the control means 131 into an interdiction state and is maintained in such an interdiction state, until the bus voltage V_{DC} returns below the third safety value V_{S3}. According to an alternative embodiment of the present invention, if an over-voltage event is determined to occur during a switching cycle T (i.e. during the first switching period T_{ON} or during the second switching period T_{OFF}), the control means 131 simply operate the switching device 130, so that this latter is subject to one or more sequences BURST of state commutations.

Also in this case, the switching device 130 is preferably operated so as to be subject to one or more sequences BURST of state commutations, until the switch voltage V_{CE} returns below a second safety value V_{S2}.

Further, at the end of the one or more sequences BURST of state commutations, the control means 131 preferably operate the switching device 130, so that this latter commutates into an interdiction state and is maintained in said interdiction state, until the rate of change of the bus voltage V_{DC} or the bus voltage V_{DC} gets below a third safety value V_{S3}.

This solution is apparently less sophisticated than the embodiment of the present invention that has been described above.

Nonetheless, it has the remarkable advantage of simplifying the control procedure implemented by the control means 131, thereby reducing the computational load.

In a further aspect, the present invention relates to a method for operating the power supply device 100.

The method, according to the invention, comprises the step of determining the occurrence of an over-voltage event, on the base of detection data or signals D₁, S₁ indicative the behaviour of the bus voltage V_{DC} and the step of operating the switching device 130, so as to bring or maintain the switch voltage V_{CE}, within predefined safety limits, when an over-voltage event is determined.

Preferably, the method, according to the invention, comprises the step of operating the switching device 130, so that this latter commutates into an interdiction state, if said over-voltage event is determined to occur during a first portion (e.g. 0-50%) of the switching period T_{ON} of a switching cycle T.

Preferably, the method, according to the invention, comprises the step of operating the switching device 130, so that this latter maintains said interdiction state, until the rate of change of bus voltage V_{DC} or the bus voltage V_{DC} is below the first safety value V_{S1}. Preferably, the method, according to the invention, comprises the step of operating the switching device 130, so that this latter is subject to one or more sequences BURST of state commutations, if said over-voltage event is determined to occur during a second portion (e.g. 50-100%) of the switching period T_{ON} or during the switching period T_{OFF}.

Preferably, the method, according to the invention, comprises the step of operating the switching device 130, so that this latter is subject to one or more sequences BURST of state commutations, until the switch voltage V_{CE} is below the second safety value V_{S2}.

Preferably, the method, according to the invention, comprises the step of operating the switching device 130, so that this latter commutates into an interdiction state, at the end of said one or more sequences of state commutations.

Preferably, the method, according to the invention, comprises the step of operating the switching device 130, so that this latter maintains said interdiction state, until the rate of change of the bus voltage V_{DC} or the bus voltage V_{DC} is below the third safety value V_{S3}. According to an alternative embodiment, the method, according to the invention, comprises the step of operating the switching device 130, so that this latter is subject to one or more sequences BURST of state commutations, if said over-voltage event is determined to occur during a switching cycle T (i.e. during the first switching period T_{ON} or during the second switching period T_{OFF}).

Also in this case, the method, according to the invention, may comprise the steps of:
- operating the switching device 130, so that this latter is subject to one or more sequences BURST of state commutations, until the switch voltage V_{CE} is below the second safety value V_{S2};
- operating the switching device 130, so that this latter commutates into an interdiction state, at the end of said sequences BURST of state commutations;
- operating the switching device 130, so that this latter maintains said interdiction state, until the rate of change of the bus voltage V_{DC} or the bus voltage V_{DC} is below the third safety value V_{S3}.

The power supply device 100 and the operating method thereof, according to the present invention, fully allow the achievement of the intended aims and objects.

The control means 131 determine the occurrence of a possible over-voltage event only on the base of information related to the behaviour of the bus voltage V_{DC}.

The occurrence of a possible over-voltage event is thus checked before the switch voltage reaches excessive values or before the resonant capacitor C_{RES} stores an excessive amount of electric energy.

The approach proposed by the present invention allows the control means 131 to efficiently use pieces of information that are already available to them, since the bus voltage V_{DC} is typically monitored also during normal operations of the power supply device 100.

On the base of the information so acquired, the control means 131 intervene on the commutation state of the switching device 130, which is forced to operate in emergency conditions, until the over-voltage event is overcome.

Advantageously, the switching device 130 is operated so as to prevent the excessive storage of electric energy in the resonant tank or to gradually dissipate the electric energy that has possibly been stored in said resonant tank.

The power supply device 100 thus ensures an effective protection of the switching device 130 from over-voltage phenomena without dedicated hardware.

The power supply device 130 has thus a simplified circuit structure with respect to the devices of the state of the art.

The power supply device 130 has proven to be relatively easy and relatively cheap to manufacture at industrial level.

## Claims

1. A power supply device (100) for a household appliance comprising:
- a switching converter (110) that comprises a rectifying stage (12), electrically connected with the mains (10), a bus capacitor (13), electrically connected in parallel with output terminals of said rectifying stage (12), a resonant tank (200) electrically connected with one terminal (A) of said bus capacitor (13), and a switching device (130), electrically connected with said resonant tank and another terminal (B) of the bus capacitor (13);
- control means (131) for controlling the operation of said switching device, said control means operating, in normal conditions, said switching device with a switching cycle (T) that comprises a first switching period (T_{ON}) in which said switching device is in a conduction state (ON) and allows the flow of a first current (Is) between said bus capacitor (13) and said resonant tank (200), and a second switching period (T_{OFF}), in which said switching device is in an interdiction state (OFF) and blocks the flow of said first current (Is);
wherein said control means (131) are configured to:
- determine the occurrence of an over-voltage event on the base of detection data or signals (D₁, S₁) indicative of the behaviour of a bus voltage (V_{DC}) across the terminals (A, B) of said bus capacitor (13);
- operate said switching device (130) so as to bring or maintain a switch voltage (V_{CE}) across output terminals (C, E) of said switching device within predefined safety limits, when the occurrence of an over-voltage event is determined;
- operate said switching device (130) so that said switching device commutates into said interdiction state, if said over-voltage event is determined to occur during a first portion of said first switching period (T_{ON});
- operate said switching device (130) so that said switching device maintains said interdiction state, until the rate of change of said bus voltage (V_{DC}) or said bus voltage (V_{DC}) is below a first safety value (V_{S1});
- **characterised in that** said control means are further configured to:
operate said switching device (130) so that said switching device is subject to one or more sequences (BURST) of state commutations, if said over-voltage event is determined to occur during a second portion of said first switching period (T_{ON}) or during said second switching period (T_{OFF}),
- wherein said state commutations of each sequences (BURST) have a duration (T_{BURST}) that is shorter than the switching cycle (T).

2. A power supply device, according to claim 1, **characterised in that** said control means (131) operate said switching device (130), so that said switching device is subject to one or more sequences (BURST) of state commutations, until said switch voltage (V_{CE}) is below a second safety value (V_{S2}).

3. A power supply device, according to claim 2, **characterised in that** said control means (131) operate said switching device (130), so that said switching device commutates into an interdiction state, at the end of said one or more sequences (BURST) of state commutations.

4. A power supply device, according to claim 1, **characterised in that** the density of the state commutations of a sequence (BURST) of state commutations decreases during the execution of said sequence of state commutations.

5. A power supply device, according to claim 3, **characterised in that** said control means (131) operate said switching device (130), so that said switching device maintains said interdiction state, until the rate of change of said bus voltage (V_{DC}) or said bus voltage (V_{DC}) is below a third safety value (V_{S3}).

6. A household appliance **characterised in that** it comprises a power supply device (100), according to one or more of the previous claims.

7. A method for operating a power supply device (100) for a household appliance, said power supply device comprising a switching converter (110) that comprises a rectifying stage (12), electrically connected with the mains (10), a bus capacitor (13), electrically connected in parallel with output terminals of said rectifying stage (12), a resonant tank (200) electrically connected with one terminal (A) of said bus capacitor (13), and a switching device (130), electrically connected with said resonant tank and another terminal (B) of the bus capacitor; said method comprising the step of operating, in normal conditions, said switching device with a first switching cycle (T) that comprises a first switching period (T_{ON}), in which said switching device is in a conduction state and allows the flow of a first current (Is) between said bus capacitor (13) and said resonant tank (200), and a second switching period (T_{OFF}), in which said switching device is in an interdiction state and blocks the flow of said first current (I_{S}), **characterised in that** it comprises the steps of:
- determining the occurrence of an over-voltage event, on the base of detection data or signals (D₁, S₁) indicative the behaviour of a bus voltage (V_{DC}) across the terminals (A, B) of said bus capacitor (13);
- operating said switching device (130), so as to bring or maintain a switch voltage (V_{CE}), across output terminals (C, E) of said switching device, within predefined safety limits,
when the occurrence of an over-voltage event is determined,
- operating said switching device (130), so that said switching device commutates into an interdiction state, if said over-voltage event is determined to occur during a first portion of said first switching period (T_{ON}),
- operating said switching device (130), so that said switching device maintains said interdiction state, until the rate of change of said bus voltage (V_{DC}) or said bus voltage (V_{DC}) is below a first safety value (V_{S1}),
**characterised in that** it comprises the step of operating said switching device (130) so that said switching device is subject to one or more sequences (BURST) of state commutations, if said over-voltage event is determined to occur during a second portion of said first switching period (T_{ON}) or during said second switching period (T_{OFF}), wherein said state commutations of each sequences (BURST) have duration (T_{BURST}) that is shorter that the switching cycle (T).

8. A method, according to claim 7, **characterised in that** it comprises the step of operating said switching device (130), so that said switching device is subject to one or more sequences (BURST) of state commutations, until said switch voltage (V_{CE}) is below a second safety value (V_{S2}).

9. A method, according claim 8, **characterised in that** it comprises the step of operating said switching device (130), so that said switching device commutates into an interdiction state, at the end of said one or more sequences (BURST) of state commutations.

10. A method, according to one or more of the claims from 7 to 9, **characterised in that** the density of the state commutations of a sequence (BURST) of state commutations decreases during the execution of said sequence of state commutations.

11. A method, according to claim 9, **characterised in that** it comprises the step of operating said switching device (130), so that said switching device maintains said interdiction state, until the rate of change of said bus voltage (V_{DC}) or said bus voltage (V_{DC}) is below a third safety value (V_{S3}).

## Patentansprüche

1. Stromversorgungsvorrichtung (100) für ein Haushaltsgerät, umfassend:
- ein Schaltnetzteil (110), welches eine Gleichrichterstufe (12), welche mit dem Netz (10) elektrisch verbunden ist, einen Buskondensator (13), welcher mit Ausgangsklemmen der Gleichrichterstufe (12) parallel elektrisch verbunden ist, einen Resonanzkreis (200), welcher mit einer Klemme (A) des Buskondensators (13) elektrisch verbunden ist, und eine Schaltvorrichtung (130), welche mit dem Resonanzkreis und einer anderen Klemme (B) des Buskondensators (13) elektrisch verbunden ist, umfasst;
- Steuermittel (131) zum Steuern des Betriebs der Schaltvorrichtung, wobei die Steuermittel unter normalen Bedingungen die Schaltvorrichtung mit einem Schaltzyklus (T) betreiben, welcher eine erste Schaltperiode (T_{ON}), in welcher die Schaltvorrichtung sich in einem Verbindungszustand (ON) befindet und den Fluss eines ersten Stroms (I_{S}) zwischen dem Buskondensator (13) und dem Resonanzkreis (200) erlaubt, und eine zweite Schaltperiode (T_{OFF}), in welcher die Schaltvorrichtung sich in einem Verbotszustand (OFF) befindet und den Fluss des ersten Stroms (I_{S}) blockiert, umfasst;
wobei die Steuermittel (131) konfiguriert sind, um:
- das Auftreten eines Überspannungsereignisses auf der Basis von Erkennen von Daten oder Signalen (D₁, S₁) zu bestimmen, welche das Verhalten einer Busspannung V(_{DC}) an den Klemmen (A, B) des Buskondensators (13) anzeigen;
- die Schaltvorrichtung (130) zu betreiben, sodass eine Schaltspannung (V_{CE}) an den Ausgangsklemmen (C, E) der Schaltvorrichtung innerhalb von vordefinierten Sicherheitsgrenzen angelegt oder bewahrt wird, wenn das Auftreten eines Überspannungsereignisses bestimmt wird;
- die Schaltvorrichtung (130) zu betreiben, sodass die Schaltvorrichtung in den Verbotszustand umschaltet, wenn bestimmt wird, dass das Überspannungsereignis während eines ersten Abschnitts der ersten Schaltperiode (T_{ON}) auftritt;
- die Schaltvorrichtung (130) zu betreiben, sodass die Schaltvorrichtung den Verbotszustand bewahrt, bis die Änderungsrate der Busspannung (V_{DC}) oder die Busspannung (V_{DC}) unter einem ersten Sicherheitswert (V_{S1}) liegt;
- **dadurch gekennzeichnet, dass** die Steuermittel weiter konfiguriert sind, um:
- die Schaltvorrichtung (130) zu betreiben, sodass die Schaltvorrichtung einer oder mehrerer Abfolgen (BURST) von Zustandsumschaltungen unterzogen wird, wenn bestimmt wird, dass das Überspannungsereignis während eines zweiten Abschnitts der ersten Schaltperiode (T_{ON}) oder während der zweiten Schaltperiode (T_{OFF}) auftritt,
- wobei die Zustandsumschaltungen jeder Abfolge (BURST) eine Dauer (T_{BURST}) aufweisen, welche kürzer ist als der Schaltzyklus (T).

2. Stromversorgungsvorrichtung nach Anspruch 1, **dadurch gekennzeichnet, dass** die Steuermittel (131) die Schaltvorrichtung (130) betreiben, sodass die Schaltvorrichtung einer oder mehreren Abfolgen (BURST) von Zustandsumschaltungen unterzogen wird, bis die Schaltspannung (V_{CE}) unter einem zweiten Sicherheitswert (V_{S2}) liegt.

3. Stromversorgungsvorrichtung nach Anspruch 2, **dadurch gekennzeichnet, dass** die Steuermittel (131) die Schaltvorrichtung (130) betreiben, sodass die Schaltvorrichtung am Ende der einen oder mehreren Abfolgen (BURST) von Zustandsumschaltungen in einen Verbotszustand umschaltet.

4. Stromversorgungsvorrichtung nach Anspruch 1, **dadurch gekennzeichnet, dass** die Dichte der Zustandsumschaltungen einer Abfolge (BURST) von Zustandsumschaltungen während der Ausführung der Abfolge von Zustandsumschaltungen abnimmt.

5. Stromversorgungsvorrichtung nach Anspruch 3, **dadurch gekennzeichnet, dass** Steuermittel (131) die Schaltvorrichtung (130) betreiben, sodass die Schaltvorrichtung den Verbotszustand bewahrt, bis die Änderungsrate der Busspannung (V_{DC}) oder die Busspannung (V_{DC}) unter einem dritten Sicherheitswert (V_{S3}) liegt;

6. Haushaltsgerät, **dadurch gekennzeichnet, dass** es eine Stromversorgungsvorrichtung (100) nach einem oder mehreren der vorstehenden Ansprüche umfasst.

7. Verfahren zum Betreiben einer Stromversorgungsvorrichtung (100) für ein Haushaltsgerät, wobei die Stromversorgungsvorrichtung ein Schaltnetzteil (110), welches eine Gleichrichterstufe (12), welche mit dem Netz (10) elektrisch verbunden ist, einen Buskondensator (13), welcher mit Ausgangsklemmen der Gleichrichterstufe (12) parallel elektrisch verbunden ist, einen Resonanzkreis (200), welcher mit einer Klemme (A) des Buskondensators (13) elektrisch verbunden ist, und eine Schaltvorrichtung (130), welche mit dem Resonanzkreis und einer anderen Klemme (B) des Buskondensators elektrisch verbunden ist, umfasst; wobei das Verfahren den Schritt des Betreibens, unter normalen Bedingungen, der Schaltvorrichtung mit einem Schaltzyklus (T), welcher eine erste Schaltperiode (T_{ON}), in welcher die Schaltvorrichtung sich in einem Verbindungszustand befindet und den Fluss eines ersten Stroms (I_{S}) zwischen dem Buskondensator (13) und dem Resonanzkreis (200) erlaubt, und eine zweite Schaltperiode (T_{OFF}), in welcher die Schaltvorrichtung sich in einem Verbotszustand befindet und den Fluss des ersten Stroms (I_{S}) blockiert, umfasst; **dadurch gekennzeichnet, dass** es die folgenden Schritte umfasst:
- Bestimmen des Auftretens eines Überspannungsereignisses auf der Basis von Erkennen von Daten oder Signalen (D₁, S₁), welche das Verhalten einer Busspannung V(_{DC}) an den Klemmen (A, B) des Buskondensators (13) anzeigen;
- Betreiben der Schaltvorrichtung (130), sodass eine Schaltspannung (V_{CE}) an den Ausgangsklemmen (C, E) der Schaltvorrichtung innerhalb von vordefinierten Sicherheitsgrenzen angelegt oder bewahrt wird, wenn das Auftreten eines Überspannungsereignisses bestimmt wird,
- Betreiben der Schaltvorrichtung (130), sodass die Schaltvorrichtung in den Verbotszustand umschaltet, wenn bestimmt wird, dass das Überspannungsereignis während eines ersten Abschnitts der ersten Schaltperiode (T_{ON}) auftritt,
- Betreiben der Schaltvorrichtung (130), sodass die Schaltvorrichtung den Verbotszustand bewahrt, bis die Änderungsrate der Busspannung (V_{DC}) oder die Busspannung (V_{DC}) unter einem ersten Sicherheitswert (V_{S1}) liegt,
**dadurch gekennzeichnet, dass** es den Schritt des Betreibens der Schaltvorrichtung (130) umfasst, sodass die Schaltvorrichtung einer oder mehrerer Abfolgen (BURST) von Zustandsumschaltungen unterzogen wird, wenn bestimmt wird, dass das Überspannungsereignis während eines zweiten Abschnitts der ersten Schaltperiode (T_{ON}) oder während der zweiten Schaltperiode (T_{OFF}) auftritt, wobei die Zustandsumschaltungen jeder Abfolge (BURST) eine Dauer (T_{BURST}) aufweisen, welche kürzer ist als der Schaltzyklus (T).

8. Verfahren nach Anspruch 7, **dadurch gekennzeichnet, dass** es den Schritt des Betreibens der Schaltvorrichtung (130) umfasst, sodass die Schaltvorrichtung einer oder mehreren Abfolgen (BURST) von Zustandsumschaltungen unterzogen wird, bis die Schaltspannung (V_{CE}) unter einem zweiten Sicherheitswert (V_{S2}) liegt.

9. Verfahren nach Anspruch 8, **dadurch gekennzeichnet, dass** es den Schritt des Betreibens der Schaltvorrichtung (130) umfasst, sodass die Schaltvorrichtung am Ende der einen oder mehreren Abfolgen (BURST) von Zustandsumschaltungen in einen Verbotszustand umschaltet.

10. Verfahren nach einem oder mehreren der Ansprüche 7 bis 9, **dadurch gekennzeichnet, dass** die Dichte der Zustandsumschaltungen einer Abfolge (BURST) von Zustandsumschaltungen während der Ausführung der Abfolge von Zustandsumschaltungen abnimmt.

11. Verfahren nach Anspruch 9, **dadurch gekennzeichnet, dass** es den Schritt des Betreibens der Schaltvorrichtung (130) umfasst, sodass die Schaltvorrichtung den Verbotszustand bewahrt, bis die Änderungsrate der Busspannung (V_{DC}) oder die Busspannung (V_{DC}) unter einem dritten Sicherheitswert (V_{S3}) liegt;

## Revendications

1. Dispositif d'alimentation électrique (100) pour appareil électroménager comprenant :
- un convertisseur de commutation (110) qui comprend un étage de redressement (12), relié électriquement au secteur (10), un condensateur de bus (13), relié électriquement en parallèle à des bornes de sortie dudit étage de redressement (12), un réservoir résonant (200) relié électriquement à une borne (A) dudit condensateur de bus (13), et un dispositif de commutation (130), relié électriquement audit réservoir résonant et à une autre borne (B) du condensateur de bus (13) ;
- des moyens de commande (131) pour commander le fonctionnement dudit dispositif de commutation, lesdits moyens de commande actionnant, dans des conditions normales, ledit dispositif de commutation avec un cycle de commutation (T) qui comprend une première période de commutation (T_{ON}), dans laquelle ledit dispositif de commutation est dans un état de conduction (ON) et autorise le passage d'un premier courant (I_{S}) entre ledit condensateur de bus (13) et ledit réservoir résonant (200), et une seconde période de commutation (T_{OFF}), dans laquelle ledit dispositif de commutation est dans un état d'interdiction (OFF) et bloque le passage dudit premier courant (I_{S}) ;
dans lequel lesdits moyens de commande (131) sont configurés pour :
- déterminer la survenue d'un événement de surtension, sur la base de données ou de signaux de détection (D₁, S₁) indicatifs du comportement d'une tension de bus (V_{DC}) aux bornes (A, B) dudit condensateur de bus (13) ;
- actionner ledit dispositif de commutation (130) de manière à amener ou maintenir une tension de commutateur (V_{CE}), à des bornes de sorties (C, E) dudit dispositif de commutation, dans des limites de sécurité prédéfinies, lorsque la survenue d'un événement de surtension est déterminée ;
- actionner ledit dispositif de commutation (130), de sorte que ledit dispositif de commutation commute dans ledit état d'interdiction, s'il est déterminé que ledit événement de surtension est survenu durant une première partie de ladite première période de commutation (T_{ON}) ;
- actionner ledit dispositif de commutation (130) de sorte que ledit dispositif de commutation maintienne ledit état d'interdiction, jusqu'à ce que la vitesse de changement de ladite tension de bus (V_{DC}) ou ladite tension de bus (V_{DC}) soit inférieure à une première valeur de sécurité (V_{S1}) ;
- **caractérisé en ce que** lesdits moyens de commande sont configurés en outre pour :
- actionner ledit dispositif de commutation (130) de sorte que ledit dispositif de commutation soit soumis à une ou plusieurs séquences (BURST) de commutations d'état, s'il est déterminé que ledit événement de surtension est survenu durant une seconde partie de ladite première période de commutation (T_{ON}) ou durant ladite seconde période de commutation (T_{OFF}),
- dans lequel lesdites commutations d'état de chaque séquence (BURST) ont une durée (T_{BURST}) qui est plus courte que le cycle de commutation (T).

2. Dispositif d'alimentation électrique selon la revendication 1, **caractérisé en ce que** lesdits moyens de commande (131) actionnent ledit dispositif de commutation (130), de sorte que ledit dispositif de commutation soit soumis à une ou plusieurs séquences (BURST) de commutations d'état, jusqu'à ce que la vitesse de changement de ladite tension de commutateur (V_{CE}) soit inférieure à une deuxième valeur de sécurité (V_{S2}).

3. Dispositif d'alimentation électrique selon la revendication 2, **caractérisé en ce que** lesdits moyens de commande (131) actionnent ledit dispositif de commutation (130), de sorte que ledit dispositif de commutation commute dans un état d'interdiction, à la fin desdites une ou plusieurs séquences (BURST) de commutations d'état.

4. Dispositif d'alimentation électrique selon la revendication 1, **caractérisé en ce que** la densité des commutations d'état d'une séquence (BURST) de commutations d'état diminue durant l'exécution de ladite séquence de commutations d'état.

5. Dispositif d'alimentation électrique selon la revendication 3, **caractérisé en ce que** lesdits moyens de commande (131) actionnent ledit dispositif de commutation (130), de sorte que ledit dispositif de commutation maintienne ledit état d'interdiction, jusqu'à ce que la vitesse de changement de ladite tension de bus (V_{DC}) ou ladite tension de bus (V_{DC}) soit inférieure à une troisième valeur de sécurité (V_{S3}).

6. Appareil électroménager **caractérisé en ce qu'**il comprend un dispositif d'alimentation électrique (100) selon une ou plusieurs des revendications précédentes.

7. Procédé pour actionner un dispositif d'alimentation électrique (100) pour appareil électroménager, ledit dispositif d'alimentation électrique comprenant un convertisseur de commutation (110) qui comprend un étage de redressement (12), relié électriquement au secteur (10), un condensateur de bus (13), relié électriquement en parallèle à des bornes de sortie dudit étage de redressement (12), un réservoir résonant (200) relié électriquement à une borne (A) dudit condensateur de bus (13), et un dispositif de commutation (130), relié électriquement audit réservoir résonant et à une autre borne (B) du condensateur de bus ; ledit procédé comprenant l'étape d'actionnement, dans des conditions normales, dudit dispositif de commutation avec un cycle de commutation (T) qui comprend une première période de commutation (T_{ON}), dans laquelle ledit dispositif de commutation est dans un état de conduction et autorise le passage d'un premier courant (I_{S}) entre ledit condensateur de bus (13) et ledit réservoir résonant (200), et une seconde période de commutation (T_{OFF}), dans laquelle ledit dispositif de commutation est dans un état d'interdiction et bloque le passage dudit premier courant (I_{S}), **caractérisé en ce qu'**il comprend les étapes suivantes :
- détermination de la survenue d'un événement de surtension, sur la base de données ou de signaux de détection (D₁, S₁) indicatifs du comportement d'une tension de bus (V_{DC}) aux bornes (A, B) dudit condensateur de bus (13) ;
- actionnement dudit dispositif de commutation (130), de manière à amener ou maintenir une tension de commutateur (V_{CE}), à des bornes de sorties (C, E) dudit dispositif de commutation, dans des limites de sécurité prédéfinies, lorsque la survenue d'un événement de surtension est déterminée,
- actionnement dudit dispositif de commutation (130), de sorte que ledit dispositif de commutation commute dans un état d'interdiction, s'il est déterminé que ledit événement de surtension est survenu durant une première partie de ladite première période de commutation (T_{ON}),
- actionnement dudit dispositif de commutation (130), de sorte que ledit dispositif de commutation maintienne ledit état d'interdiction, jusqu'à ce que la vitesse de changement de ladite tension de bus (V_{DC}) ou ladite tension de bus (V_{DC}) soit inférieure à une première valeur de sécurité (V_{S1}).
**caractérisé en ce qu'**il comprend l'étape d'actionnement dudit dispositif de commutation (130) de sorte que ledit dispositif de commutation soit soumis à une ou plusieurs séquences (BURST) de commutations d'état, s'il est déterminé que ledit événement de surtension est survenu durant une seconde partie de ladite première période de commutation (T_{ON}) ou durant ladite seconde période de commutation (T_{OFF}), dans lequel lesdites commutations d'état de chaque séquence (BURST) ont une durée (T_{BURST}) qui est plus courte que le cycle de commutation (T).

8. Procédé selon la revendication 7, **caractérisé en ce qu'**il comprend l'étape d'actionnement dudit dispositif de commutation (130), de sorte que ledit dispositif de commutation soit soumis à une ou plusieurs séquences (BURST) de commutations d'état, jusqu'à ce que ladite tension de commutateur (V_{CE}) soit inférieure à une deuxième valeur de sécurité (V_{S2}).

9. Procédé selon la revendication 8, **caractérisé en ce qu'**il comprend l'étape d'actionnement dudit dispositif de commutation (130), de sorte que ledit dispositif de commutation commute dans un état d'interdiction, à la fin desdites une ou plusieurs séquences (BURST) de commutations d'état.

10. Procédé selon une ou plusieurs des revendications 7 à 9, **caractérisé en ce que** la densité des commutations d'état d'une séquence (BURST) de commutations d'état diminue durant l'exécution de ladite séquence de commutations d'état.

11. Procédé selon la revendication 9, **caractérisé en ce qu'**il comprend l'étape d'actionnement dudit dispositif de commutation (130), de sorte que ledit dispositif de commutation maintienne ledit état d'interdiction, jusqu'à ce que la vitesse de changement de ladite tension de bus (V_{DC}) ou ladite tension de bus (V_{DC}) soit inférieure à une troisième valeur de sécurité (V_{S3}).
